# EUROPÄISCHE PATENTSCHRIFT

(11) **EP 1 231 295 B1**
(45) Veröffentlichungstag und Bekanntmachung des Hinweises auf die Patenterteilung: **27.09.2006**
(21) Anmeldenummer: 02002310.7
(22) Anmeldetag: 31.01.2002
(51) Int. Cl.: C23C 30/00, C23C 16/40

(54) **Hartmetallverschleissteil mit Mischoxidschicht**
Hard wearing metal part coated with mixed oxides
Pièce d'usure en métal dur revêtue d'oxydes mixtes

(30) Priorität: 09.02.2001 AT 1022001
(43) Veröffentlichungstag der Anmeldung: 14.08.2002
(73) Patentinhaber: CERATIZIT Austria Gesellschaft m.b.H., 6600 Reutte /Tirol (AT)
(72) Erfinder: Kathrein, Martin, Dipl.-Ing., 6600 Reutte (AT); Schintlmeister, Wilfried, Dr., 6600 Reutte (AT); Wallgram, Wolfgang, 6600 Breitenwang (AT)

(56) Entgegenhaltungen:
- EP-A- 0 492 059
- WO-A-00/17416
- WO-A-99/29921
- US-A- 4 599 281
- US-A- 4 746 563

## Beschreibung

Die Erfindung betrifft ein Verschleißteil, insbesondere einen Schneideinsatz aus Hartmetall oder Cermet als dem Basiswerkstoff und mit einem eine oder mehrere Schichten aufweisenden Hartstoffüberzug, wobei eine den Verschleiß wesentlich bestimmende ein- oder lamellar mehrlagige Mischoxidschicht überwiegend aus Aluminiumoxid besteht.

Die verschleißfestigkeitssteigerende Wirkung von Hartstoffschichten auf Hartmetall und auf Cermets wird seit vielen Jahren kommerziell genutzt. Unter den vielen zwischenzeitlich zum Verschleißschutz verwendeten Hartstoffphasen haben sich einmal solche Hartstoffe aus der Gruppe der Karbide und Karbonitride, Nitride, andererseits solche aus der Gruppe der Oxide besonders bewährt und werden heute vielfach als sich ergänzende Schutzschichten in lagenweiser Schichtfolge gemeinsam genutzt.

Dabei ist es üblich, Schichten einer Hartstoffgruppe lamellar in Gestalt mehrerer Einzellagen abwechselnd aus unterschiedlichen Hartstoffen auszuführen, um den verschiedenartigen Anforderungen an ein Verschleißteil, insbesondere auch an einen Schneideinsatz für die Zerspanung von metallischen Werkstoffen hinsichtlich Haftung, Zähigkeit und niedrigem Verschleiß gerecht zu werden.

Die Herstellung brauchbarer Aluminiumoxid-Schichten auf Hartmetall Schneideinsätzen weist eine Reihe bekannter Schwierigkeiten auf. Die Schicht, versprödet mit zunehmender Schichtdicke und mit zunehmender Schichtabscheiderate infolge Schicht-Kornvergröberung beträchtlich. Die zur Erzielung der gewünschten Aluminiumoxidphase (Anteil von α- und oder κ Al₂O₃) und Schichtstruktur erforderlichen hohen Beschichtungstemperaturen bergen die Gefahr bleibender Qualitätseinbußen für den Basiswerkstoff; Außerdem führen sie zu vermehrten thermischen Spannungen in der Schicht.

Der permanent gegebenen Forderung nach Oxidschichten mit gegenüber reinem Al₂O₃ verbesserter Verschleißfestigkeit, insbesondere bei Schneideinsätzen, ist man in der Vergangenheit auf verschiedenartige Weise nachgekommen.

Die EP 0 162 656 beschreibt mehrlagig beschichtete Hartmetalle, unterteilt nach Unterlagsschicht und Deckschicht, wobei jede der beiden Schichten wiederum in mehrere Lagen unterschiedlicher Hartstoffzusammensetzung aufgeteilt sein kann. Die mehrlagige Außenschicht mit einer Gesamtschichtdicke von 3 bis 20 µm besteht aus einer Mehrzahl von Al₂O₃-Lagen von jeweils 0,01 bis 2 µm Dicke, wobei in der Al₂O₃-Phase bis zu 30 Vol.% von Titandioxid enthalten sein können, wobei die einzelnen Al₂O₃-Lagen der Außenschicht durch 0,1 bis 2 µm dicke Zwischenlagen von Ti(C,N,O,B) sowie SiC, AIN und AION unterbrochen bzw. abgelöst sind. Gemäß dem Ausführungsbeispiel erfolgt die Al₂O₃-CVD-Beschichtung bei 1.000° Ofentemperatur.
Diese Schichtfolgen und Abscheidebedingungen lassen angesichts der angegebenen Schichtdicken von 3 bis 20 µm lange Beschichtungszeiten und damit ein zeit- und kostenintensives Beschichtungsverfahren erkennen. Die langen Beschichtungszeiten bedingen zudem Qualitätseinbußen im Hartmetallbasiswerkstoff.

So beschreibt die DE OS 27 18 647 die Auftragung eines Mischüberzuges aus Al₂O₃ und TiO₂-Phasen auf Werkzeugen für die spanabhebende Bearbeitung. Entsprechend der dort näher beschriebenen Ausführung beträgt die Titanoxidkonzentration im Überzug 2 - 10 % und liegt in Form einer eigenen zweiten Phase im Aluminiumoxid als dispergiertes, hexagonales α-Titanoxid vor. Die für derart beschichtete Schneidewerkzeuge erzielbaren Standzeiterhöhungen gegenüber reinem Al₂O₃ entsprechen nicht mehr dem heute auf andere Weise erzielbaren Verschleißfestigkeitsstandard für Schneideinsätze.

Die EP 0 083 043 als weiteres Beispiel für die Fortentwicklung von Al₂O₃-Schichten betrifft ein Verschleißteil, insbesondere einen Hartmetallschneideinsatz zur spanabhebenden Bearbeitung mit einem mehrschichtigen Hartstoffüberzug, wobei mindestens eine Schicht aus Oxiden, Nitriden, Karbiden und/oder Boriden in Verwendung einzelner Metalle wie Titan, Zirkonium und Hafnium besteht, die im Wechsel mit mindestens einer Aluminium-Bor-Mischoxidschicht mit Borgehalten von 0,01 bis 1 Gew.% aufgebracht ist.
Derartig beschichtete Verschleißteile sind bis heute kommerziell im praktischen Einsatz. Dessen ungeachtet besteht die Forderung nach weiterer Verschleißfestigkeitssteigerung bzw. Standzeiterhöhungen, sowie nach Reduzierung der Fertigungskosten für beschichtete Schneideinsätze.
Die Schneidkantenstabilität bzw. Schneidkanten-Ausbruchssicherheit ist für eine zuverlässig störungsfreie Werkstückbearbeitung von großer Wichtigkeit und gilt gegenüber diesem Stand der Technik als vordringlich verbesserungsbedürftig.

Aufgabe vorliegender Erfindung ist es daher, der ständigen Forderung nach verbesserter Verschleißfestigkeit und Schneidkantenstabilität von Verschleißteilen, insbesondere von Schneideinsätzen für die spanabhebende Bearbeitung, bei weiterer Reduzierung der Fertigungskosten nachzukommen.

Diese Aufgabe wird für ein Verschleißteil der eingangs spezifizierten Gattung erfindungsgemäß dadurch gelöst, dass die ein- oder mehrlagige Al₂O₃-Mischoxidschicht 0,5 bis 10 µm dick ist und in der Al₂O₃-Phase homogen verteilt und im Wesentlichen gelöst, einen Zusatz von 0,1 bis < 3 Gew.% TiO₂ und 0,01 bis 0,5 Gew.% B₂O₃ enthält.

Die Gewichtsanteile an Titan- und Boroxid in der Al₂O₃-Mischoxidschicht sind auf die Verbindungen TiO₂ und B₂O₃ bezogen. Über die tatsächlich vorliegenden Verbindung ist damit nichts ausgesagt.

Das Al₂O₃ in der Mischoxidschicht kann aus einer oder mehreren Al₂O₃-Modifikationen, beispielsweise α Al₂O₃, κ Al₂O₃ oder anderen bestehen.

Die Festlegung der maximal einbringbaren Titan- und Boroxid Zusätze in die Al₂O₃-Phase und die dabei anzuwendenden Fertigungsparameter sind mittels dem Fachmann geläufiger Regeln so aufeinander abzustimmen, dass die Zusätze tatsächlich vollständig im Al₂O₃ gelöst oder zu einem Anteil auch so fein homogen im Al₂O₃ verteilt sind, dass diese lichtmikroskopisch nicht als eigenständige Titan- bzw. Boroxid-Phase neben der Al₂O₃-Phase erkennbar sind.
Der im Anspruch für die Zusätze gebrauchte Begriff "wesentlich" innerhalb des Merkmals "homogen verteilt und im Wesentlichen gelöst" definiert daher eine Al₂O₃-Mischoxidphase, innerhalb der eine Ti-Oxid- oder B-Oxid-Phase lichtmikroskopisch nicht nachweisbar ist, gleichgültig welcher Anteil des Zusatzes tatsächlich den Bedingungen an eine feste Lösung genügt.

Ein Verschleißteil mit einer derart ausgeführten Al₂O₃-Deckschicht zeichnet sich durch vergleichsweise kürzere Fertigungszeiten und damit niedrigere Fertigungskosten aus.
Gleichzeitig wird infolge der erfindungsgemäß modifizierten Al₂O₃₋Mischoxidschicht eine unerwartete Verschleißfestigkeitssteigerung erzielt, was an Hand der Ausführungsbeispiele weiter unten glaubhaft belegt wird.

Bei ansonsten unmittelbar vergleichbaren Schichtabscheidebedingungen ist im Falle der erfindungsgemäßen Al₂O₃-Mischoxidschicht eine sprunghaft höhere Abscheiderate erzielbar, als für Al₂O₃-Mischoxidschichten nach dem Stand der Technik. Höhere Abscheideraten bedeuten aber eine Reduzierung der Beschichtungszeit, oder eine Absenkung der Beschichtungstemperatur für die Formierung einer Schicht bestimmter Dicke.
Höhere Abscheideraten sind indes nur dann und in einem solchen Ausmaß technisch sinnvoll, als dadurch die Körnigkeit einer Schicht nicht unvertretbar zunimmt, denn bekanntermaßen besitzen feinkörnige Schichten tendenziell höhere Verschleißfestigkeit und besseres Zähigkeitsverhalten als grobkörnige Schichten.
Überraschenderweise geht bei der Abscheidung der erfindungsgemäß modifizierten Al₂O₃-Mischoxidschichten eine Erhöhung der Abscheiderate im Ausmaß bis größenordnungsmäßig um den Faktor 3 nicht mit der üblicherweise vom Fachmann erwarteten Erhöhung der Korngröße einher.

Als Regel gilt, dass sich die Abscheiderate bei CVD-, PACVD- (plasma activated chemical vapour deposition) und PVD-Beschichtungen tendenziell mit der Temperatur im Reaktionsraum bzw. an der Verschleißteiloberfläche erhöht.

Die Nutzung der zuvor beschriebenen, überraschend hohen Abscheideraten für die Al₂O₃-Mischoxidschichten gemäß vorliegender Erfindung gestattet es, die Reaktionstemperatur im Beschichtungsraum zu senken, z.B. bei der thermischen CVD-Beschichtung von 1.050°C auf 990°C und tiefer und dessen ungeachtet eine zwar kleinere, aber im Hinblick auf vertretbar kurze Prozessdauer nach wie vor ausreichend hohe Abscheiderate zu erzielen.
Die Absenkung jeder der beiden Parameter, sowohl der Abscheiderate als auch der Temperatur im Beschichtungsraum, bedeutet aber eine vergleichsweise bedeutende Kornverfeinerung für die abgeschiedene Schicht und damit eine höchst vorteilhafte Verschleißfestigkeitssteigerung bei erhöhter Schneidkantenstabilität. Durch eine Abscheidung bei tieferer Temperatur wird das Schneidmaterial weniger belastet und weiters werden thermische Spannungen in der Schicht reduziert.

In vorteilhafter Nutzung der oben beschriebenen Zusammenhänge lässt sich für das erfindungsgemäße Verschleißteil daher in Summe sowohl eine bedeutsame Steigerung von Verschleißfestigkeit, Zähigkeit und Kantenstabilität dank verfeinerten Schichtkornes bzw. dank des Verfahrensablaufs bei tieferen Temperaturen erzielen, als auch eine wesentliche Wirtschaftlichkeitssteigerung dank kürzerer Beschichtungszeiten.

Eine bevorzugte Ausführung des Verschleißteiles gemäß Erfindung weist zwischen Basiswerkstoff und ein- oder mehrlagiger Mischoxidschicht eine ein- oder mehrlagige Unterlagsschicht aus Karbiden, Nitriden und/oder Boriden, insbesondere auch aus Karbonitriden auf.

Zum Stand der Technik ist bereits die Aufteilung einer Al₂O₃-Schicht in einzelne dünne Lagen jeweils im Wechsel mit Ti-C,N,B,O haltigen oder TiAl-C,N,B,O haltigen Zwischenlagen beschrieben worden. Dabei sind dort wie auch in vorliegender Erfindung die Formeln so zu verstehen, dass die Zwischenlagen nicht gleichzeitig sämtliche Elemente C, N, B und O in Summe enthalten müssen. Nach einer bevorzugten Ausgestaltung der Verschleißteiles gemäß vorliegender Erfindung weisen die Zwischenlagen neben Titan die Elemente Kohlenstoff und Stickstoff oder Bor und Stickstoff zwingend und die übrigen Elemente wahlweise auf.
Nach einer weiteren bevorzugten Ausführung der Erfindung ist zwischen ein- oder mehrlagiger Unterlagsschicht aus Karbiden, Nitriden und/oder Boriden und der ein- oder mehrlagigen Mischoxidschicht eine 0,5 - 2 µm dicke, fallweise auch weniger als 0,5 µm dicke Titan-Bornitrid-Schicht angebracht. Entsprechend einer bevorzugten Ausführung der Erfindung enthält das Verschleißteil auf die Mischoxidschicht nach außen folgend eine weitere 0,5 bis 3 µm dicke ein- oder mehrlagige Schicht aus einem oder mehreren Hartstoffen der Zusammensetzung Metall (C,N,B) auf. Die Schicht enthält ggf. kleine Anteile an Sauerstoff bzw. an einer Oxidphase.
Nach einer bevorzugten Ausführung folgt auf dem Verschleißteil auf die vorgenannte, weitere Hartstoffschicht eine weitere ein- oder mehrlagige Mischoxidschicht.

Die Basiswerkstoffe des Verschleißteiles gemäß Erfindung sind Hartmetall oder Cermet, wobei unter Hartmetall ein Sinterverbund aus Karbid-Hartstoffpartikeln und einem Bindermaterial, z.B. Kobalt und/oder Nickel verstanden wird, während unter Cermet eine Gruppe von Sinterverbundwerkstoffen, bestehend aus Karbid-Nitrid-Hartstoffen als Hauptbestandteil der Hartstoff-Phasen und einem oder mehreren Metallen der Eisen-Gruppe vornehmlich überwiegend aus Nickel als Bindermaterial zu verstehen ist.

Für die Aufbringung von Hartstoffschichten auf Hartmetall und Cermets wurden probeweise verschiedenartige bekannte Beschichtungsverfahren adaptiert und haben sind zur Fertigung von Verschleißteilen gemäßvorliegender Erfindung bewährt. Bevorzugt wird das CVD-Verfahren (chemical vapour deposition Verfahren) unter Normaldruck- oder Unterdruckbedingungen mit Untervarianten, wie dem Plasma-CVD-Verfahren auf vorliegende Erfindung angewandt.

Ein bekanntes CVD-Verfahren zur Erzielung vergleichsweise höherer Abscheideraten ist die Zugabe von H₂S zum Reaktionsgas, wie dies beispielsweise in der EP 0 045 291 beschrieben ist.

Beispielsweise nennt das dortige Beispiel 6 für die Abscheidung von Al₂O₃ bei 1.030°C eine Rate von
- 0,33 µm / h bei Zugabe von H₂S
- 0,17 µm / h bei Atmosphären ohne H₂S-Anteilen.

Diese Erkenntnis lässt sich bei vorliegender Erfindung ebenfalls nutzen, entweder zur weiteren Verkürzung der Beschichtungszeit oder auch zur weiteren Absenkung der Beschichtungstemperatur auf beispielsweise 930°C oder tiefer.

Alternativ zu den CVD-Verfahren mit einer Gasatmosphäre von Normal- oder Unterdruck lassen sich auch verschiedene PVD (Physical Vapor Deposition) Verfahren zur Umsetzung vorliegender Erfindung nutzen, beispielsweise das Magnetron-Sputtern von metallischen Schichtkomponenten von einem Sputter Target in einer mit Bor und Sauerstoff hältigen Gasphase.

Bei Nutzung von PACVD- und PVD-Verfahren lässt sich die erfindungsgemäße Mischoxidschicht vorteilhafterweise direkt auf dem Basiswerkstoff aufbringen. Auf die anfängliche Abscheidung einer ein- oder mehrlagigen Unterlagsschicht aus Karbiden, Nitriden und/oder Boriden kann verzichtet werden.
Weiters hat sich in Verbindung mit PACVD- und PVD-Verfahren die Abscheidung von zunächst einer (Ti,Al)N-Schicht auf dem Basiswerkstoff, gefolgt von der erfindungsgemäßen Mischoxidschicht bewährt. Weiters können Ti,Al-N,B,C,O haltige Zwischenlagen, beispielsweise (Ti,Al)N, vorteilhaft sein.

Die vorliegende Erfindung wird an Hand nachfolgender Ausführungsbeispiele, einschließlich zugehöriger Schichtgefügebilder und Graphiken zu Zerspanungsversuchen beschrieben.

### Beispiel 1

In Beispiel 1 wird ein Verschleißteil mit modifizierter Al₂O₃-Mischoxidschicht gemäß Erfindung mit Verschleißteilen nach dem eingangs genannten Stand der Technik, d.h. mit anders modifizierten Al₂O₃-Mischoxidschichten verglichen.

Zu diesem Zweck wurden handelsübliche Hartmetallschneideinsätze der Zusammensetzung WC, 8 Gew.% Mischkarbid, 6 Gew.% Co und der Type CNMG 120408 zunächst jeweils mit einer Unterlagsschicht beschichtet und weiterhin

| | |
|---|---|
| Probe 1 | mit modifizierter Al₂O₃-Mischoxidschicht gemäß Erfindung |
| Probe 2 | mit einer Al₂O₃-Mischoxidschicht gemäß EP 0 162 656 (Al₂O₃ plus TiO₂, gelöst) |
| Probe 3 | mit einer Al₂O₃-Mischoxidschicht gemäß EP 0 083 043 (Al₂O₃ plus Boroxid). |

Die Proben dieses Vergleichstests wurden in einer produktionstauglichen CVD-Beschichtungsanlage unter Normaldruck bei einer Beschichtungstemperatur von 990°C bei miteinander vergleichbarer Zusammensetzung der Beschichtungsatmosphäre (gleich, ausgenommen die Titan und Bor enthaltenden Gaskomponenten) und jeweils an gleicher Stelle im Ofenraum beschichtet.

Sämtliche Proben erhielten an den Basiswerkstoff anschließend, zunächst eine zweilagige Unterlagsschicht, bestehend jeweils aus einer ca. 4,5 µm dicken, kohlenstoffreichen Karbonitridschicht, gefolgt von einer ca. 3 µm dicken stickstoffreicheren Karbonitridschicht.
Die Mischoxidschicht in Form einer modifizierten Aluminiumoxid-Schicht war für jede Probe einlagig und war bei den Proben mit Boroxidanteil einheitlich etwa 2,6 µm dick, bei der Mischoxidschicht ohne Boroxidanteil (Probe 2) uneinheitlich dick zwischen 1,5 und 4 µm schwankend.

Es wurden folgende Abscheideraten ermittelt:

| | |
|---|---|
| Probe 1 | 0,8 µm pro Stunde |
| Probe 2 | 0,4 bis 1,1 µm Pro Stunde, örtlich sehr unterschiedlich |
| Probe 3 | 0,44 µm pro Stunde. |

Die erfindungsgemäße Probe 1 zeigt somit eine etwa doppelt so hohe Schichtabscheiderate auf wie die Vergleichsproben nach dem Stand der Technik.
Die Probe 2 weist im Einzelnen neben Bereichen niedriger Abscheiderate in anderen Bereichen auch hohe Abscheideraten auf, was eine sehr nachteilig unebene Probenoberfläche zur Folge hat.

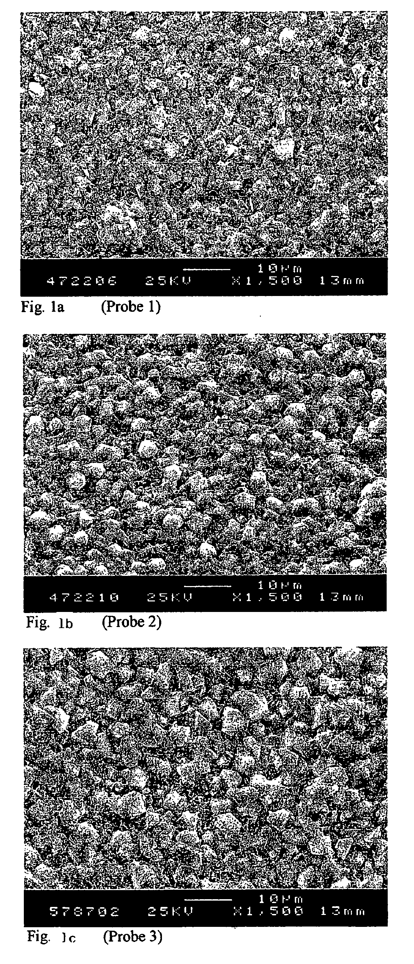

Die zu den Proben 1 bis 3 in dieser Reihenfolge ermittelten Oberflächenbilder Figur 1 a/ bis c/ zeigen bei gleichem Vergrößerungsmaßstab in einer REM-Aufnahme die unterschiedliche Struktur, Korngröße und Korngrößenverteilung der jeweiligen Schichten.
Dabei sind die vorteilhaften Werte hinsichtlich vergleichsweise kleiner Korndurchmesser und gleichmäßiger Komgrößenverteilung für die Probe 1 gemäß vorliegender Erfindung augenfällig.

Die Proben 1 bis 3 wurden zum Vergleich einem qualitativen Zerspanungstest unterzogen. Dabei zeigte sich die überlegene Verschleißfestigkeit von Probe 1, dem Schneideinsatz gemäß Erfindung, gegenüber den Proben, gefertigt nach dem Stand der Technik.
Bezüglich eines quantitativen Verschleißtests wird auf nachfolgende Beispiele 2 und 3 verwiesen, in denen die jeweiligen Mischoxidschichten entsprechend dem heute üblichen Standard als mehrlagige Schicht ausgeführt waren.

### Beispiel 2

Beschaffenheit der Proben 4 und 5 entspricht Beispiel 1 hinsichtlich Basiswerkstoff, und Type bzw. Geometrie des Hartmetall-Schneideinsatzes, zusätzlich wurden Hartmetall-Schneideinsätze der Type CNMA 120408 beschichtet, sowie bezüglich der Beschichtungsparameter für Unterlagsschichten und Mischoxidschichten.

| | |
|---|---|
| Probe 4 | entsprechend vorliegender Erfindung |
| Probe 5 | mit Al₂O₃-TiO₂-Mischoxidschicht |

Es wurden folgende Abscheideraten erzielt:

| | |
|---|---|
| Probe 4 | 1,0 µm pro Stunde |
| Probe 5 | 0,6 bis 0,9 µm pro Stunde |

Die Beschichtung besteht jeweils aus einer ca. 7,5 µm dicken, zweilagigen Unterlagsschicht (TiCN), gefolgt von einer dreilagigen Mischoxidschicht, wobei jede Lage von einer 0,5 µm dicken Ti(C,N,O)-Zwischenlage unterbrochen ist. Die Gesamtdicke der Mischoxidschicht (Mischoxidlagen und Ti(C,N,O)-Lagen) beträgt ca. 4,1 µm.

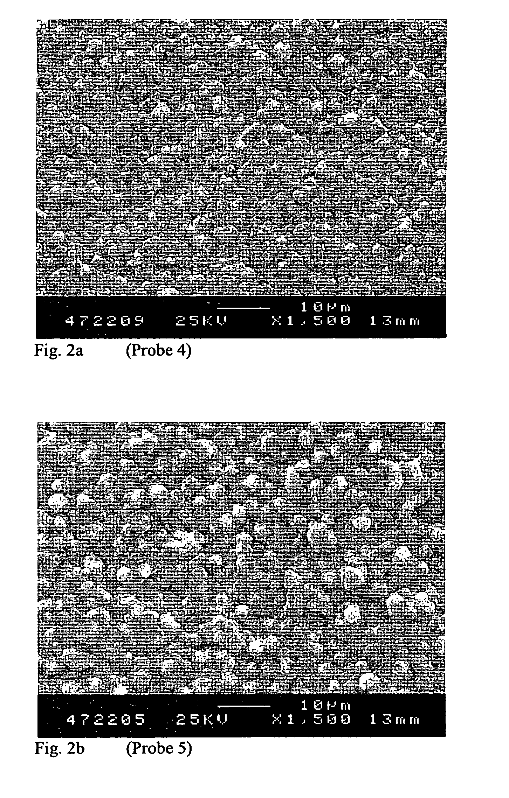

Die Figuren 2a und 2b zeigen die den Proben 4 und 5 zuzuordnenden Oberflächenbilder in Form von REM-Aufnahmen.

Die Probe 4, gefertigt gemäß Erfindung, weist eine deutlich homogenere und feinkörnigere Gefügestruktur auf als die Vergleichsprobe 5 gemäß Stand der Technik.

Die derart gefertigten Schneideinsätze wurden zur Ermittlung der Verschleißfestigkeit in zwei unterschiedlichen Zerspanungsversuchen einem Vergleichstest ausgesetzt, bei dem bei einer Verschleißmarkenbreite von 0,3 mm das Standzeitende erreicht war:
im ersten Vergleichstest wurden die Proben 4 und 5 beim Trockendrehen einer Welle aus dem Werkstoff Ck 67 mit folgenden Schnittparametem eingesetzt

| | | |
|---|---|---|
| V_{c} (Schnittgeschwindigkeit) | = | 180 m/min |
| f (Vorschub) | = | 0,21 mm / U |
| ap (Schnitttiefe) | = | 2,0 mm. |

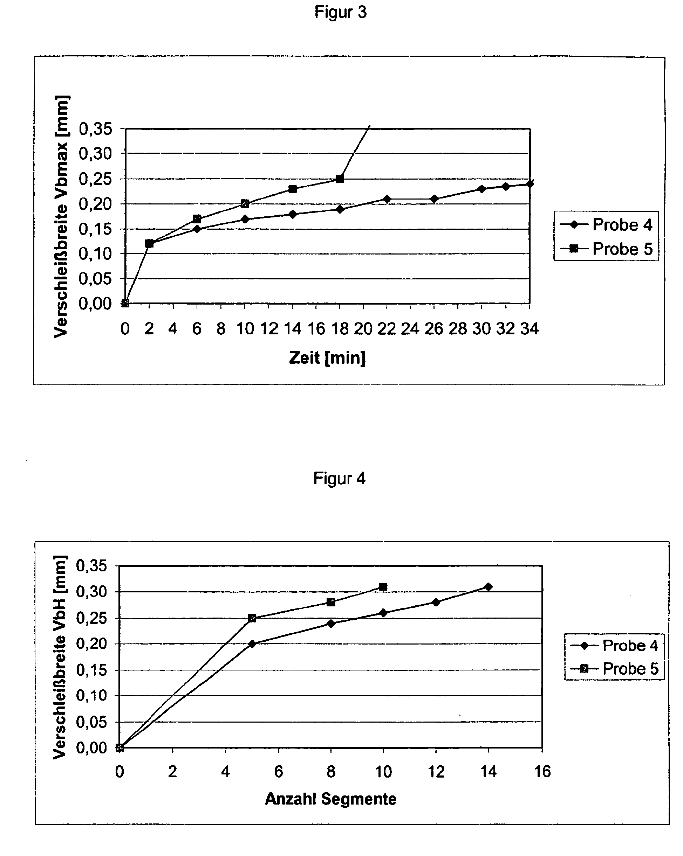

Die Figur 3 zeigt in einer Graphik die jeweils gemessene Verschleißmarkenbreite in Abhängigkeit von der Drehzeit. Während die Probe 5 nach ca. 18 min aus Verschleißgründen ausfiel, wurde der Versuch an Probe 4 nach 34 Minuten abgebrochen, ohne dass das Standzeitende erreicht war.

In einem zweiten Vergleichstest wurden die Proben 4 und 5 zum segmentweisen Drehen eines GG 25 Werkstoffes - trocken - bei folgenden Schnittparametem eingesetzt

| | |
|---|---|
| v_{c} = | 250 m/min |
| f = | 0,3 mm/Umdr. |

Figur 4 zeigt in einer Grafik die ermittelte Verschleißmarkenbreite in Abhängigkeit von der Anzahl der gedrehten Segmente für Probe 4 und 5 im Vergleich.
Der erfindungsgemäße Schneideinsatz nach Probe 4 weist gegenüber Probe 5 eine sprunghafte Verbesserung der Verschleißfestigkeit auf, und zwar konnten mit Probe 5 10 Segmente und mit Probe 4 14 Segmente gedreht werden, somit um 40 % mehr.

| | |
|---|---|
| Probe 6 | entsprechend vorliegender Erfindung, ähnlich Probe 4, jedoch 4-lagige Mischoxidschicht |
| Probe 7 | Al₂O₃-Bor-Mischoxidschicht von Probe 6 abweichende Mischoxidschicht entsprechend bekanntem Stand der Technik, ebenfalls 4-lagige Mischoxidschicht entsprechend EP 0 083 043 |

Im Vergleich wurden folgende Abscheideraten erzielt:

| | |
|---|---|
| Probe 6 | 1, 0 µm / Stunde |
| Probe 7 | 0,9 µm / Stunde (bei 1.040°C im Unterschied zu sonst 990°C Ofentemperatur) |

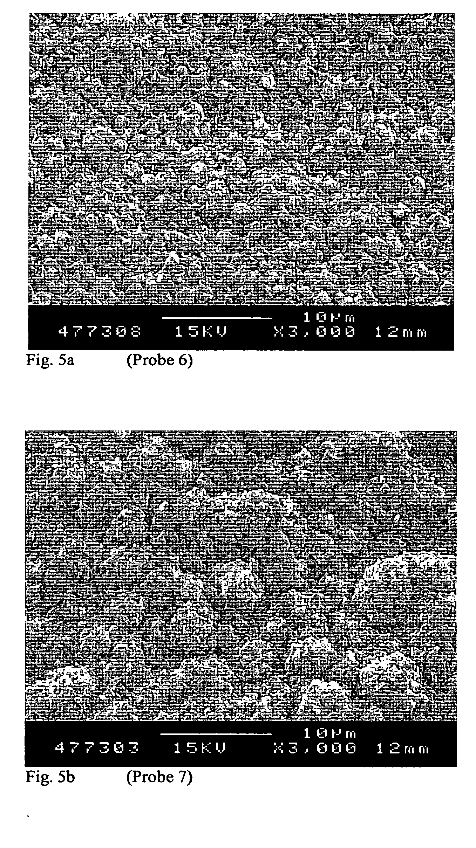

Die zugehörigen Gefügebilder sind in den Figuren 5a und 5b dargestellt. Das zu Probe 6 gehörende Gefügebild zeigt ein sehr feines, homogenes Gefüge im Vergleich zum Gefügebild der Probe 7.

In Drehversuchen wurden die Proben zur Trocken- und Nassbearbeitung verschiedener Werkstoffe bei jeweils vergleichbaren Schnittparametern eingesetzt.

Die nachfolgende Tabelle 1 zeigt die jeweilige Standzeitverbesserung der Probe 6, d.h. des erfindungsgemäßen Schneideinsatzes gegenüber der Probe 7, einem Schneideinsatz mit der Beschichtung gemäß dem eingangs zitierten Stand der Technik, wobei letztere Schneideinsätze bis heute gleichwohl weit verbreitete kommerzielle Verwendung finden.

**Tabelle 1**

| | | Parameter | | | Standzeiten [min] | | Standzeitverbesserung |
|---|---|---|---|---|---|---|---|
| Werkstof | Bedingungen | vc [m/min] | f [mm] | ap [mm] | Probe 6 | Probe 7 | |
| Ck67 | trocken | 180 | 0,21 | 2 | 20 | 14 | 43% |
| 100Cr6 | trocken | 200 | 0,25 | 2 | 24 | 15 | 60% |
| 42CrMo4 | trocken | 200 | 0,25 | 2 | 50 | 38 | über 30% |
| GG25 | trocken | 300 | 0,30 | 2 | 15 | 9 | 67% |
| GG25 | naß | 400 | 0,30 | 2 | 15 | 9 | 67% |

## Patentansprüche

1. Verschleißteil, insbesondere Schneideinsatz, aus Hartmetall oder Cermet als dem Basiswerkstoff und mit einem, eine oder mehrere Schichten umfassenden Hartstoffüberzug, wobei eine den Verschleiß wesentlich bestimmende, ein- oder lamellar mehrlagige Mischoxidschicht überwiegend aus Al₂O₃ besteht und im Falle einer lamellaren Mehrlagigkeit, von 0,05 bis 1 µm dicken Ti-C,N,B,O haltigen oder Ti,Al-C,N,B,O haltigen Zwischenlagen unterbrochen ist,
**dadurch gekennzeichnet,**
**dass** die ein- oder mehrlagige Mischoxidschicht 0,5 bis 10 µm dick ist und, in der Al₂O₃-Phase homogen verteilt und im Wesentlichen gelöst, einen Zusatz von 0,1 bis < 3 Gew.% TiO₂ und 0,01 bis 0,5 Gew.% B₂O₃ enthält.

2. Verschleißteil nach Anspruch 1, **dadurch gekennzeichnet, dass** zwischen Basiswerkstoff und Mischoxidschicht eine ein- oder mehrlagige, 1 bis 15 um dicke Unterlagsschicht aus Karbiden, Nitriden, Karbonitriden und/oder Boriden angebracht ist.

3. Verschleißteil nach Anspruch 2, **dadurch gekennzeichnet, dass** zwischen Unterlagsschicht und Mischoxidschicht eine 0,2 bis 2 µm dicke Ti(N,B)-Schicht angebracht ist.

4. Verschleißteil nach Anspruch 1 bis 3, **dadurch gekennzeichnet, dass** die Ti-C,N,B,O haltigen Zwischenlage zwischen einzelnen Mischoxidlagen der Mischoxidschicht neben Titan die Elemente Kohlenstoff und Stickstoff oder Bor und Stickstoff zwingend und die übrigen Elemente wahlweise enthält.

5. Verschleißteil nach Anspruch 1 bis 4, **dadurch gekennzeichnet, dass** auf die Mischoxidschicht nach außen folgend eine weitere 0,5 bis 3 µm dicke ein- oder mehrlagige Schicht aus einem oder mehreren Hartstoffen der Zusammensetzung Me(C,N.B), ggf. mit kleinen Oxidanteilen, aufgebracht ist.

6. Verschleißteil nach Anspruch 5, **dadurch gekennzeichnet, dass** auf die weitere Schicht aus dem Hartstoff Me(C,N,B) eine weitere ein- oder mehrlagige Mischoxidschicht aufgebracht ist.

7. Verschleißteil nach Anspruch 1 bis 6, **dadurch gekennzeichnet, dass** einzelne oder sämtliche Schichten, bzw. diese bildenden Lagen des Hartstoffüberzuges mittels CVD-Verfahren unter Normaldruck aufgebracht sind.

## Claims

1. Wear part, in particular a cutting insert, made from hard metal or cermet as the base material and having a hard material coating comprising one or more layers, wherein a single-layer or lamellar multi-layer mixed oxide coating substantially determining the wear consists predominantly of Al₂O₃ and in the case of a lamellar multi-layer structure it is separated by 0.05 to 1 *µ*m thick Ti-C,N,B,O-containing or Ti,Al-C,N,B,O-containing interlayers,
**characterised in that**
the single-layer or multi-layer mixed oxide coating is 0.5 to 10 µm thick and an addition of 0.1 to < 3 wt.% of TiO₂ and 0.01 to 0.5 wt.% of B₂O₃ is contained in the Al₂O₃ phase in a homogeneously distributed and substantially dissolved form.

2. Wear part according to claim 1, **characterised in that** a single-layer or multi-layer, 1 to 15 *µ*m thick undercoat comprising carbides, nitrides, carbonitrides and/or borides is applied between the base material and the mixed oxide coating.

3. Wear part according to claim 2, **characterised in that** a 0.2 to 2 *µ*m thick Ti(N,B) coating is applied between the undercoat and the mixed oxide coating.

4. Wear part according to claim 1 to 3, **characterised in that** in addition to titanium, the Ti-C,N,B,O-containing interlayer between individual mixed oxide layers in the mixed oxide coating is obliged to contain the elements carbon and nitrogen or boron and nitrogen, the other elements being optional.

5. Wear part according to claim 1 to 4, **characterised in that** a further 0.5 to 3 *µ*m thick single-layer or multi-layer coating comprising one or more hard materials having the composition Me(C,N,B), optionally with small amounts of oxides, is applied on top of the mixed oxide coating.

6. Wear part according to claim 5, **characterised in that** a further single-layer or multi-layer mixed oxide coating is applied on top of the additional coating comprising the hard material Me(C,N,B).

7. Wear part according to claim 1 to 6, **characterised in that** individual or all coatings, or their constituent layers, in the hard material coating are applied by CVD processes under normal pressure.

## Revendications

1. Pièce d'usure, en particulier plaquette de coupe, constituée d'un métal dur ou d'un cermet comme matière de base et pourvue d'un revêtement en substance dure comprenant une ou plusieurs couches, dans lequel une couche d'oxydes mixtes à une strate ou à plusieurs strates appliquées de façon lamellaire, qui détermine essentiellement l'usure, se compose de façon prépondérante d'Al₂O₃, et comprend en alternance, dans le cas d'une pluralité lamellaire de strates, des strates intermédiaires à teneurs en Ti-C,N,B,O ou à teneurs en Ti,AI-C,N,B,O d'une épaisseur de 0,05 à 1 µm,
**caractérisée en ce que**
la couche d'oxydes mixtes à une ou plusieurs strates est d'une épaisseur de 0,5 à 10 µm, et contient un additif composé de 0,1 à < 3% en poids de TiO₂ et de 0,01 à 0,5% en poids de B₂O₃, réparti de façon homogène et essentiellement dissout dans la phase d'Al₂O₃.

2. Pièce d'usure selon la revendication 1 **caractérisée en ce qu'**une couche de support d'une épaisseur de 1 à 15 µm à une ou plusieurs strates, constituée de carbures, de nitrures, de carbonitrures et/ou de borures, est appliquée entre la matière de base et la couche d'oxydes mixtes.

3. Pièce d'usure selon la revendication 2, **caractérisée en ce qu'**une couche de Ti(N,B) d'une épaisseur de 0,2 à 2 µm est appliquée entre la couche de support et la couche d'oxydes mixtes.

4. Pièce d'usure selon l'une quelconque des revendications précédentes, **caractérisée en ce que** la strate intermédiaire à teneur en Ti-C,N,B,O, appliquée entre des strates individuelles d'oxydes mixtes de la couche d'oxydes mixtes, contient en plus du titane, impérativement les éléments carbone et azote ou bore et azote, et facultativement les autres éléments.

5. Pièce d'usure selon l'une quelconque des revendications précédentes, **caractérisée en ce qu'**une couche additionnelle d'une épaisseur de 0,5 à 3 µm à une ou plusieurs strates, constituée d'une ou plusieurs substances dures de la composition Me(C,N,B), éventuellement avec de faibles teneurs en oxydes, est appliquée en suivant vers l'extérieur sur la couche d'oxydes mixtes.

6. Pièce d'usure selon la revendication 5, **caractérisée en ce qu'**une couche additionnelle d'oxydes mixtes à une ou plusieurs strates est appliquée sur la couche additionnelle en substance dure Me(C,N,B).

7. Pièce d'usure selon l'une quelconque des revendications précédentes, **caractérisée en ce que** certaines couches ou la totalité d'entre elles, ou celles qui constituent des strates du revêtement de substance dure, sont appliquées sous pression normale par un procédé de dépôt chimique en phase vapeur, ou CVD.
